# EUROPEAN PATENT APPLICATION

(11) **EP 2 461 239 A2**
(43) Date of publication of application: **06.06.2012**
(21) Application number: 11009466.1
(22) Date of filing: 30.11.2011
(51) Int. Cl.: G06F 3/041

(54) **Input device and image display apparatus including the same**

(30) Priority: 02.12.2010 KR 20100121722; 10.08.2011 KR 20110079735
(71) Applicant: LG Electronics Inc., Youngdungpo-gu, Seoul 150-721 (KR)
(72) Inventor: An, Sungyul, Seoul 137-724 (KR); Lee, Kyungwon, Seoul 137-724 (KR)
(74) Representative: Frenkel, Matthias Alexander

(57) **Abstract**

The image display apparatus comprises a display (100) to display an image, and an input device (200) adjacent to the display, the input device comprising a first light source unit that includes a first light emitting device (LED) to emit a first light of a first color, a second light source unit that includes a second light emitting device (LED) to emit a second light of a second color, a light guide having a plurality of light guide layers, wherein a first one of the light guide layers is provided in front of a second one of the light guide layers, wherein the first LED corresponds to the first one of the light guide layers and the second LED corresponds to the second one of the light guide layers, and the light guide combines light from the first light source unit and the second light source unit to provide an output light, a touch sensor to detect a touch input, and a light source controller to control an intensity of the output light from the light guide based on the detected touch input. Accordingly, it is possible to improve user convenience.

## Description

### CROSS-REFERENCE TO RELATED APPLICATION

This application claims the priority benefit of Korean Patent Application Nos. 10-2010-0121722, filed on December 2, 2010, and 10-2011-0079735, filed on August 10, 2011, in the Korean Intellectual Property Office, the disclosure of which is incorporated herein by reference.

### BACKGROUND OF THE INVENTION

### 1. Field of the invention

The present invention relates to an input device and an image display apparatus including the same and, more particularly, to an input device able to improve user convenience and an image display apparatus including the same.

### 2. Description of the Related Art

An image display apparatus has a function for displaying an image to a user and a function for outputting an audio signal.

In the image display apparatus, an input device is used to output a video or audio signal desired by a user or perform other setting functions.

### SUMMARY OF THE INVENTION

Therefore, the present invention has been made in view of the above problems, and it is an object of the present invention to provide an input device able to improve user convenience and an image display apparatus including the same.

It is another object of the present invention to provide an input device able to provide an interactive effect during input and an image display apparatus including the same.

In accordance with an aspect of the present invention, the above and other objects can be accomplished by the provision of an image display apparatus comprising a display to display an image, and an input device adjacent to the display, the input device comprising a first light source unit that includes a first light emitting device (LED) to emit a first light of a first color, a second light source unit that includes a second light emitting device (LED) to emit a second light of a second color, a light guide having a plurality of light guide layers, wherein a first one of the light guide layers is provided in front of a second one of the light guide layers, wherein the first LED corresponds to the first one of the light guide layers and the second LED corresponds to the second one of the light guide layers, and the light guide combines light from the first light source unit and the second light source unit to provide an output light, a touch sensor to detect a touch input, and a light source controller to control an intensity of the output light from the light guide based on the detected touch input.

In accordance with a further aspect of the present invention, there is provided an input device comprising a first light source unit including a first light emitting device (LED) to provide a first light having a first color, a second light source unit including a second light emitting device (LED) to provide a second light having a second color, a light guide having a plurality of light guide layers that includes a first light guide layer in front of a second light guide layer, wherein at least the first LED corresponds to the first light guide layer and at least the second LED corresponds to the second light guide layer, the light guide to receive the first light from the first LED at a first end of the light guide and the light guide to receive a second light from the second LED at a second end of the light guide, and the light guide to output a third light having a third color based on a combination of the first light and the second light, a touch sensor to determine a touch input, and a controller to control an intensity of the third light from the light guide based on the determined touch input.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a diagram showing an image display apparatus including an input device according to an embodiment of the present invention;
FIG. 2 is a block diagram showing an example of the input device of FIG. 1;
FIG. 3 is a block diagram showing another example of the input device of FIG. 1;
FIG. 4 is an exploded perspective view showing an example of the structure of the input device of FIG. 1;
FIG. 5 is a diagram showing an example of a coupling structure of the input device of FIG. 1;
FIG. 6 is an exploded perspective view showing another example of the structure of the input device of FIG. 1;
FIG. 7 is an exploded perspective view showing another example of the structure of the input device of FIG. 1;
FIG. 8 is an exploded perspective view showing another example of the structure of the input device of FIG. 1;
FIGs. 9A to 9E are diagrams showing various structures of a light guide of the input device of FIG. 1;
FIGs. 10 to 16 are diagrams showing various examples of light display according to touch input positions of the input device of FIG. 1;
FIGs. 17 to 19 are diagrams showing various operation examples of the image display apparatus corresponding to touch input positions;
FIG. 20 is a diagram showing another example of a coupling structure of the input device of FIG. 1;
FIG. 21 is a diagram showing various examples of light display according to touch input positions of the input device of FIG. 20;
FIGs. 22 to 26 are diagrams showing various examples of light display according to touch input strength of the input device of FIG. 1;
FIG. 27 is a block diagram of the image display apparatus of FIG. 1;
FIG. 28 is a block diagram of a controller of FIG. 27; and
FIG. 29 is a diagram showing an image display apparatus including an input device according to another embodiment of the present invention.

### DETAILED DESCRIPTION OF THE PREFERRED EMBODIMENTS

Exemplary embodiments of the present invention will be described with reference to the attached drawings.

The terms "module" and "unit" attached to describe the names of components are used herein to help the understanding of the components and thus they should not be considered as having specific meanings or roles. Accordingly, the terms "module" and "unit" may be used interchangeably.

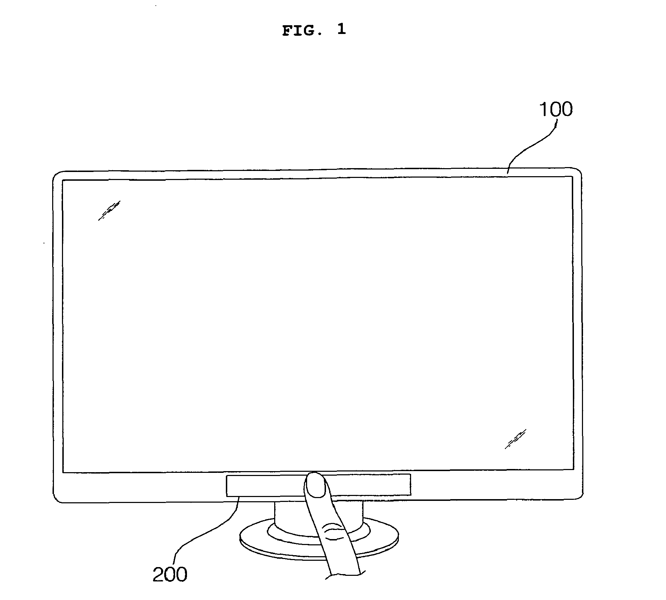

FIG. 1 is a diagram showing an image display apparatus including an input device according to an embodiment of the present invention.

Referring to FIG. 1, the input device 200 according to the embodiment of the present invention may be included in the image display apparatus 100.

In FIG. 1, the input device 200 is arranged in at least a part of a bezel area surrounding a display 180 of the image display apparatus 100.

The input device 200 according to the embodiment of the present invention includes a plurality of light source units. The input device synthesizes light emitted from the light source units and outputs the synthesized light. In particular, if a user touch input is performed with respect to the input device 200, the light emitted from each light source unit is changed in correspondence with touch information of touch input.

For example, the amount of light emitted from at least one light source unit may be changed according to touch position information of the touch information. Therefore, it is possible to provide an interactive effect in correspondence with touch input.

As another example, the amount of light emitted from at least one light source unit may be changed according to touch number information, touch strength information or touch duration information of touch information. As another example, the color of light emitted from at least one light source unit may be changed according to touch number information, touch strength information or touch duration information of the touch information. Therefore, it is possible to provide an interactive effect in correspondence with touch input.

The input device 200 may include a plurality of input keys (not shown) for inputting various input operations. The plurality of input keys may be displayed on a substrate of the input device 200 by a printing method, etc. Touch input positions may correspond to the plurality of input keys. Therefore, different input operations may be performed according to touch input positions.

The operation of the input device will now be described.

The image display apparatus described in the present specification may include a TV receiver, a mobile phone, a smart phone, a notebook computer, a digital broadcast terminal, a Personal Digital Assistant (PDA), a Portable Multimedia Player (PMP), etc.

That is, the input device 200 according to the embodiment of the present invention is applicable to various image display apparatuses, as described above. The input device 200 is applicable to electronic apparatuses such as a washing machine, a refrigerator, an air conditioner, a cooker, a cleaner or an electric iron.

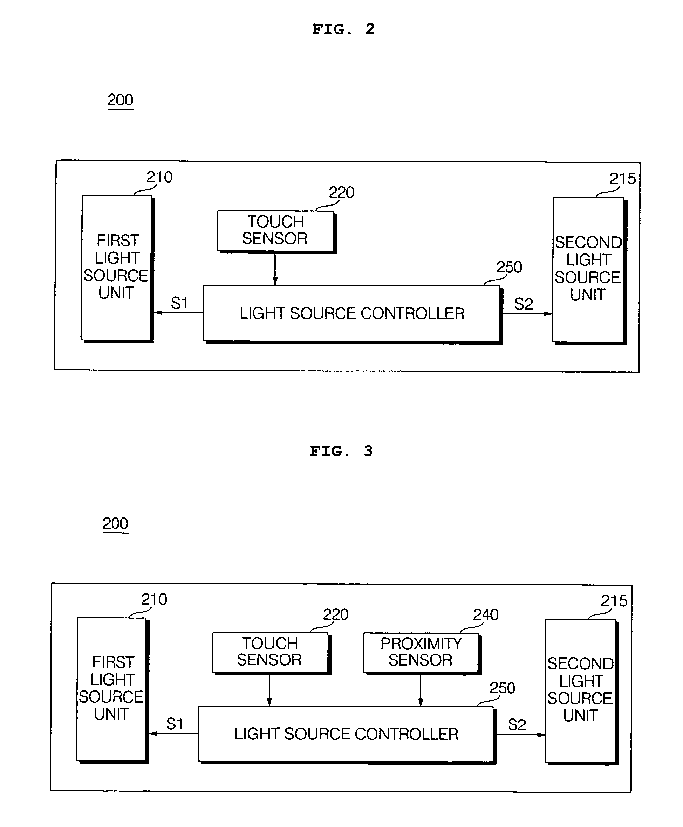

FIG. 2 is a block diagram showing an example of the input device of FIG. 1.

Referring to FIG. 2, the input device 200 according to the embodiment of the present invention includes a substrate 205, a first light source unit 210, a second light source unit 215, a touch sensor 220, a light guide 230, and a light source controller 250.

The first light source unit 210 and the second light source unit 215 are arranged spaced apart from each other and may emit respective light. The first light source unit 210 and the second light source unit 215 may emit light having the same color or different colors. Hereinafter, for convenience, it is assumed that the first light source unit 210 and the second light source unit 215 emit light having different colors.

The light guide 230 synthesizes the light emitted from the first light source unit 210 and the second light source unit 215 and outputs the synthesized light. More specifically, the light guide 230 includes a plurality of light guide layers. On each light guide layer, at least one light source corresponding to at least one of the first light source unit 210 or the second light source unit 215 is provided. Each light guide layer may synthesize light emitted from the first light source unit 210 and the second light source unit 215 and output the synthesized light.

For example, the light guide 230 may include a first light guide layer 230a and a second light guide layer 230b.

A light source 210a included in the first light source 210 to output light having a first color and a second light source 215a included in the second light source unit 215 to output light having a second color may be provided on the first light guide layer 230a. A third light source 210b included in the first light source unit 210 to output light having a third color and a fourth light source 215b included in the second light source unit 215 to output light having a fourth color may be provided on the second light guide layer 230b.

As another example, one light source may be provided on each of the two light guide layers. For example, a first light source 210a included in the first light source unit 210 to output light having a first color may be provided on the first light guide layer 230a and a second light source 215a included in the second light source unit 215 to output light having a second color may be provided on the second light guide layer 230b.

As another example, only light sources belonging to the first light source unit 210 may be provided on any one of the two light guide layers and only light sources belonging to the second light source unit 215 may be provided on the other light guide layer. For example, first, second and third light sources 210a, 210b and 210c included in the first light source unit 210 to output light having different colors may be provided on the first light guide layer 230a and fourth, fifth and sixth light sources 215a, 215b and 215c included in the second light source unit 215 to output light having different colors may be provided on the second light guide layer 230b.

As another example, first and second light sources 210a and 210b belonging to the first light source unit 210 and third and fourth light sources 215a and 215b belonging to the second light source unit 215 may be provided on any one of the two light guide layers and a fifth light source 210c belonging to the first light source unit and a sixth light source 215c belonging to the second light source unit 215 may be provided on the other light guide layer.

As another example, the light guide unit 230 may include a first light guide layer 230a, a second light guide layer 230b and a third light guide layer 230c.

For example, a first light source 210a and a second light source 215a may be provided on the first light guide layer 230a, a third light source 210b and a fourth light source 215b may be provided on the second light guide layer 230b, and a fifth light source 210c included in the first light source unit 210 to output light having a fifth color and a sixth light source 215c included in the second light source unit 215 to output light having a sixth color may be provided on the third light guide layer 230c.

The light guide 230 may include at least one of a first direction pattern from the first light source unit 210 to the second light source unit 215 or a second direction pattern from the second light source unit 215 to the first light source unit 210.

Each of such direction patterns may be formed in any one of the plurality of light guide layers. The first direction pattern may be formed in the first light guide layer 230a and the second direction pattern may be formed in the second light guide layer 230b.

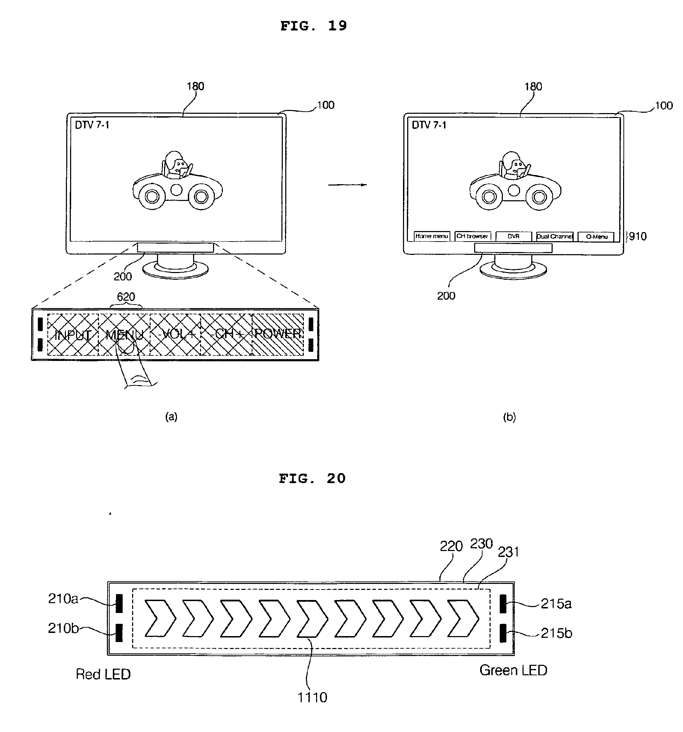

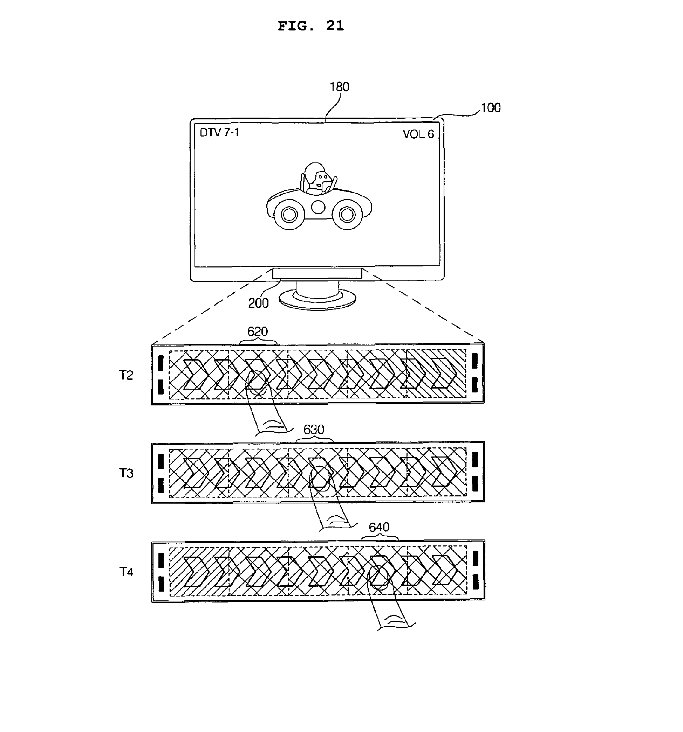

When a touch input is moved from the first light source unit 210 to the second light source unit 215, the amount of synthesized light is changed and the directivity of the light is increased, which will be described below with reference to FIGs. 20 and 21.

In addition to the direction patterns, different patterns may be formed in the plurality of light guide layers. For example, a pattern may not be formed in the first light guide layer 210a of the light guide 230, text patterns may be formed in the second light layer 210b, and figure patterns may be formed in the third light guide layer 210c.

The touch sensor 220 detects a touch input. The detected touch information is sent to the light source controller 250. The detected touch information may include touch position information, touch number information, touch strength information or touch duration information.

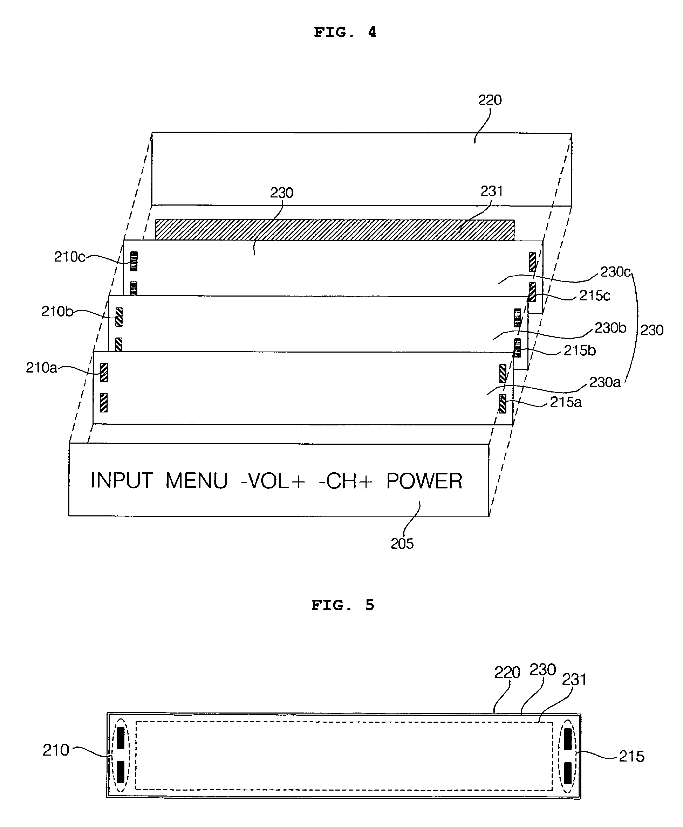

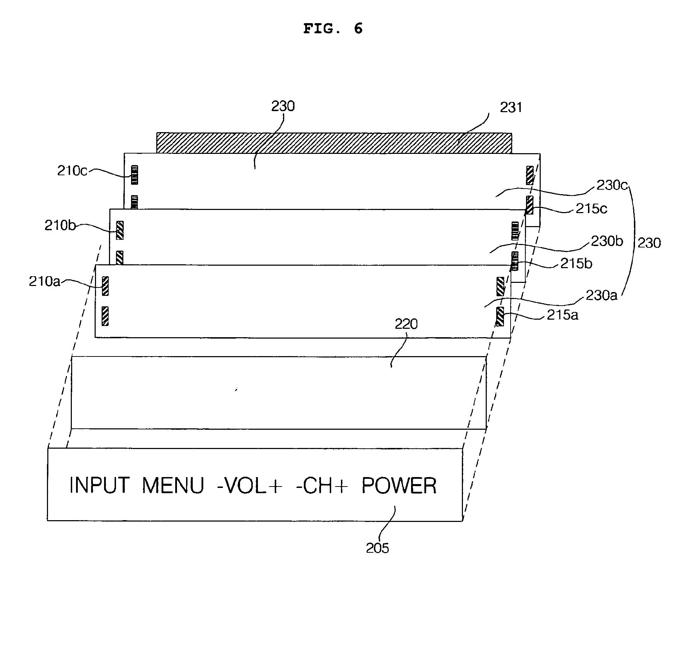

The touch sensor 220 may be implemented using various methods such as a capacitive method or a static pressure method, in order to detect the user touch input. FIG. 4 shows a static pressure touch sensor and FIG. 6 shows a capacitive touch sensor.

The light source controller 250 controls the first light source unit 210 and the second light source unit 215. In particular, at least one of a first electrical signal S1 sent to the first light source unit 210 or a second electrical signal S2 sent to the second light source unit 215 is changed according to the touch information detected by the touch sensor 220.

For example, the light source controller 250 may increase the level or pulse width of the first electrical signal S1 and/or decrease the level or pulse width of the second electrical signal S2, as the touch position information of the touch information detected by the touch sensor 220 becomes closer to the second light source unit 215 than the first light source unit 210.

That is, the light source controller 250 may control increase in the amount of light emitted from the first light source unit 210 and/or decrease in the amount of light emitted from the second light source unit 215, as the touch position information of the touch information detected by the touch sensor 220 becomes closer to the second light source unit 215 than the first light source unit 210. By changing the amount of light in this way, the user can perceive an interactive effect corresponding to the touch input.

The light source controller 250 may change the amount of the light emitted from the first light source unit and the amount of light emitted from the second light source unit in inverse proportion to each other according to the touch position information of the touch information.

The light source controller 250 may change the level, pulse width or period of the first electrical signal Sl and/or the level, pulse width or period of the second electrical signal S2, according to the touch number information, touch strength information or touch duration information of the touch information detected by the touch sensor 220.

For example, the light source controller 250 may further increase the level or pulse width of the first electrical signal Sl and/or further decrease the level or pulse width of the second electrical signal S2, when the number of times of touch, the touch strength or the touch duration is increased in a state in which the touch position information of the detected touch information becomes closer to the second light source unit 215 than the first light source unit 210.

That is, the light source controller 250 may control increase of the amount of light emitted from the first light source unit 210 and/or decrease of the amount of light emitted from the second light source unit 215.

In particular, if the number of times of touch, the touch strength or the touch duration is increased, the light source controller 250 may control further increase of the amount of light emitted from the first light source unit 210 and/or further decrease of the amount of light emitted from the second light source unit 215. By changing the amount of light in this way, the user can perceive an interactive effect corresponding to the touch input.

As another example, the light source controller 250 may change at least one of the period of the first electrical signal S1 or the period of the second electrical signal S2, when the number of times of touch, the touch strength or the touch duration of the detected touch information is changed.

That is, the color of the light emitted from the first light source unit 210 and/or the color of the light emitted from the second light source unit 215 may be changed. By changing the color of the light, the user can perceive an interactive effect corresponding to the touch input.

The light source controller 250 may classify the touch information detected by the touch sensor 220 into touch position information, touch number information, touch strength information and touch duration information.

For example, the position information may be acquired based on a touch position information signal, the level of which is changed, of touch information signals detected by the touch sensor 220 or the touch number information, the touch strength information or the touch duration information may be acquired according to the number of pulses of the touch information signals detected by the touch sensor 220.

The light source controller 250 may control at least one of the first light source unit 210 or the second light source unit 215 such that at least one of the plurality of light guide layers emits light according to the touch number information, the touch strength information or the touch duration information of the touch information.

For example, if touch strength is at a first level, at least one of the first light source unit 210 or the second light source unit 215 may be controlled such that the first light guide layer emits light, that is, the light source provided on the first light guide layer emits light. As another example, if touch strength is at a second level, at least one of the first light source unit 210 or the second light source unit 215 may be controlled such that the second light guide layer emits light, that is, the light source provided on the second light guide layer emits light. As another example, if touch strength is at a third level, at least one of the first light source unit 210 or the second light source unit 215 may be controlled such that the third light guide layer emits light, that is, the light source provided on the third light guide layer emits light.

FIG. 3 is a block diagram showing another example of the input device of FIG. 1.

Referring to FIG. 3, the input device of FIG. 3 is different from the input device of FIG. 2 in that a proximity sensor 240 is further included. Hereinafter, only this difference will be described.

The proximity sensor 240 detects a user's finger which approaches the input device within a predetermined range and may be implemented using a sensor using light (photosensor, etc.), a high-frequency oscillator circuit, etc. The detected signal is input to the light source controller 250.

The light source controller 250 may control emission of light from at least one of the first light source unit 210 or the second light source unit 220, if it is determined that a user approaches the input device within a predetermined range.

That is, if the user does not approach the input device within the predetermined range, in order to reduce power consumption, the first light source unit 210 and the second light source unit 215 are in an idle state in which light is not emitted. Then, when the proximity sensor 240 detects that the user approaches the input device within the predetermined range, at least one of the first light source unit 210 and the second light source unit 215 emits light. Thereafter, the user may perform a touch input operation in a state in which the first light source unit 210 or the second light source unit 215 is activated.

FIG. 4 is an exploded perspective view showing an example of the structure of the input device of FIG. 1, and FIG. 5 is a diagram showing an example of a coupling structure of the input device of FIG. 1.

Referring to FIGs. 4 and 5, the first light source unit 210 and the second light source unit 215 may be arranged spaced apart from each other.

The light guide 230 includes a plurality of light guide layers. On each light guide layer, at least one light source corresponding to at least one of the first light source unit 210 or the second light source unit 215 is provided. Each light guide layer may synthesize light emitted from the first light source unit 210 and the second light source unit 215 and output the synthesized light.

In FIG. 4, the light guide 230 includes a plurality of light guide layers and, more particularly, a first light guide layer 230a, a second light guide layer 230b and a third light guide layer 230c.

Light sources 210a, 210b and 210c of the first light source unit 210 are respectively provided on the left side of the first to third light guide layers 230a, 230b and 230c and light sources 215a, 215b and 215c of the second light source unit 215 may be respectively provided on the right side of the first to third light guide layers 230a, 230b and 230c.

In each of the light source units 210 and 215, a light emitting diode (LED) may be used as a light source. The LED may be an inorganic LED or an organic LED.

The first light source unit 210 and the second light source unit 215 may include a plurality of light sources for emitting light having different colors, respectively. The light source units 210 and 215 may emit light having different colors according to conditions.

In FIG. 4, on the first light guide layer 230a, a light source 210a for emitting red (R) light is provided as the light source of the first light source unit 210 and a light source 215a for emitting green (G) light is provided as the light source of the second light source unit 215. In addition, on the second light guide layer 230b, a light source 210a for emitting green (G) light is provided as the light source of the first light source unit 210 and a light source 215a for emitting blue (B) light is provided as the light source of the second light source unit 215. In addition, on the third light guide layer 230c, a light source 210a for emitting blue (B) light is provided as the light source of the first light source unit 210 and a light source 215a for emitting red (R) light is provided as the light source of the second light source unit 215.

For example, the light sources 210a and 215a provided on the first light guide layer 230a of the light guide 230 may respectively output the red light and the green light and the first light guide layer 230a may output the synthesized light, according to a first touch input.

As another example, the light sources 210b and 215b provided on the second light guide layer 230b of the light guide 230 may respectively output the green light and the blue light and the second light guide layer 230b may output the synthesized light, according to a second touch input.

As another example, the light sources 210c and 215c provided on the third light guide layer 230c of the light guide 230 may respectively output the blue light and the red light and the third light guide layer 230c may output the synthesized light, according to a third touch input.

The first to third touch inputs may be divided according to the number of times of touch, the touch strength or the touch duration.

The light guide 230 guides the light emitted from the first light source unit 210 toward the second light source unit 215 and guides the light emitted from the second light source unit 215 toward the first light source unit 210.

For example, if the touch input is moved from the first light source unit 210 to the second light source unit 215 in a state in which the light sources 210a and 215a provided on the first light guide layer 230a of the light guide 230 respectively output the red light and the green light and the first light guide layer 230a outputs the synthesized light by the first touch input, the amount of light emitted from the first light source unit 210 may be increased to be greater than the amount of light emitted from the second light source unit 215. Thus, it is possible to display the synthesized light according to the changed amount of light.

The light guide 230 may include at least one of the first direction pattern from the first light source unit 210 to the second light source unit 215 or the second direction pattern from the second light source unit 215 to the first light source unit 210. If the touch input is moved from the first light source unit 210 to the second light source unit 215, the amount of synthesized light is changed and the directivity of the light is improved, which will be described below with reference to FIGs. 20 and 21.

The touch sensor 220 may be provided below the light guide 230. The touch sensor 220 may be implemented by a printed circuit board (PCB).

The touch sensor 220 of FIG. 4 may be implemented by a static pressure method, in order to detect a user touch input. Touch information detected by the touch sensor 220 is sent to the light source controller 250.

A reflection layer 321 may be disposed between the light guide 230 and the touch sensor 220 such that the synchronized light output from the light guide 230 is not directed to the touch sensor 220. By this reflection layer 321, the light synthesized by the light guide 230 may be output toward the substrate 205.

FIG. 5 shows the appearance of the input device 200 in which the substrate 205, the light guide 230 and the touch sensor 230 are sequentially connected, as shown in FIG. 4. The input device 200 may be implemented in the form of a module. The light source controller 250 and the proximity sensor 240 may be disposed on a rear surface of the touch sensor 230 implemented by a PCB.

The substrate 205 transmits and outputs the light synthesized by the light guide 230. In this case, the substrate 205 may be formed of a transparent material. For example, the substrate 205 may be formed of glass or a transparent film.

A plurality of input keys may be displayed on the substrate 205. For example, a plurality of input keys such as INPUT, MENU, -VOL, VOL+, -CH, CH+ and POWER may be displayed. More specifically, a plurality of input keys may be displayed on the transparent substrate 205 by a printing method, etc.

The input keys displayed on the substrate 205 are preferably displayed so as to be easily recognized from the synthesized light. The input keys displayed on the substrate may be variously changed.

As the touch input position becomes closer to the second light source units 215 than the first light source unit 210, the amount of light emitted from the first light source unit 210 is increased to be greater than the amount of light emitted from the second light source unit 215. Therefore, when the touch input position is moved, it is possible to provide a moving effect.

On the contrary to the above-described example, the light source controller 250 may further decrease the amount of light emitted from the first light source unit 210 or further increase the amount of light emitted from the second light source unit 215, as the touch input position becomes closer to the second light source unit 215 than the first light source unit 210. Therefore, when the touch input position is moved, it is possible to provide a moving effect.

FIG. 6 is an exploded perspective view showing another example of the structure of the input device of FIG. 1.

Referring to FIG. 6, the structure of the input device of FIG. 6 is similar to that of the input device of FIG. 4, except that the touch sensor 220 is disposed between the substrate 205 and the light guide 230, unlike FIG. 4 in which the touch sensor 220 is disposed on the bottom of the input device. The reflection layer 231 may be attached to the rear surface of the light guide 230.

The touch sensor 220 may be a capacitive touch sensor. The touch information detected by the touch sensor 220 is sent to the light source controller 240.

Unlike FIGs. 4 and 6, the position of the touch sensor 220 may be variously changed.

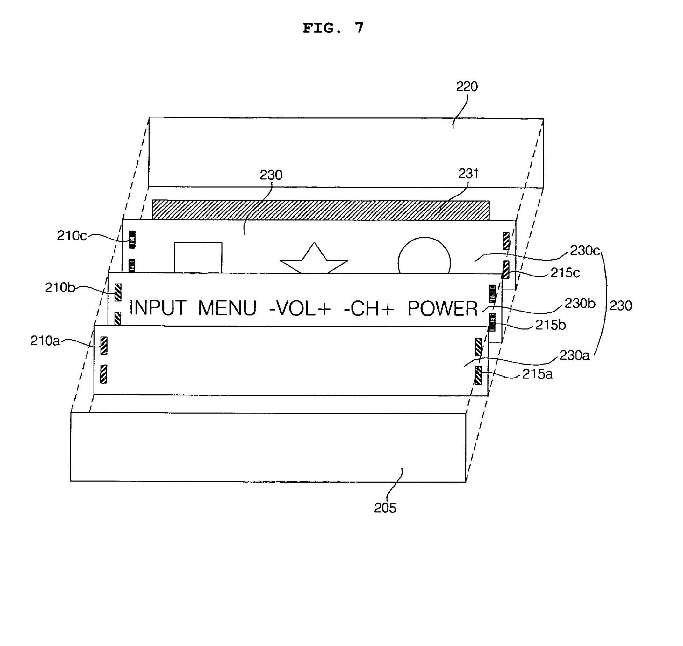

FIG. 7 is an exploded perspective view showing another example of the structure of the input device of FIG. 1.

Referring to FIG. 7, the structure of the input device of FIG. 7 is different from the structure of the input device of FIG. 4 in that a pattern is formed in at least one light guide layer.

In FIG. 7, no pattern is formed in the first light guide layer 230a, text patterns are formed in the second light guide layer, 230b similarly to the substrate shown in FIG. 4, and figure patterns are formed in the third light guide layer 230c. No text pattern is formed in the substrate 205.

For example, if the first light guide layer 230a outputs the synthesized light by the first touch input, a feedback effect may be generated by the movement of the touch input.

As another example, if the second light guide layer 230b outputs the synthesized light by the second touch input, a plurality of text patterns such as INPUT, MENU, -VOL, VOL+, -CH, CH+ and POWER may be displayed by the output light. Thus, the user may perform an input operation using such text patterns.

As another example, if the third light guide layer 230c outputs the synthesized light by the third touch input, figure patterns may be displayed by the output light. Thus, the user may perform an input operation using such figure patterns.

In the second light guide layer 230b in which the text patterns are formed, the light source 210b of the first light source unit and the light source 215b of the second light source unit may output light having the same light. In the third light guide layer 230c in which the figure patterns are formed, the light source 210c of the first light source unit and the light source 215c of the second light source unit may output light having the same light.

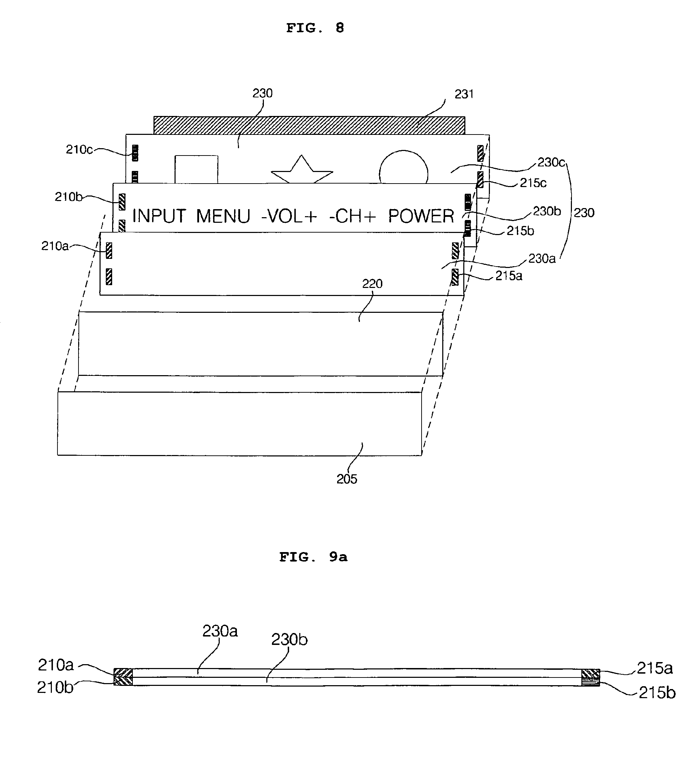

FIG. 8 is an exploded perspective view showing another example of the structure of the input device of FIG. 1.

Referring to FIG. 8, the structure of the input device of FIG. 8 is similar to the structure of the input device of FIG. 7, except that the touch sensor 220 is disposed between the substrate 205 and the light guide 230, unlike FIG. 4 in which the touch sensor 220 is disposed on the bottom of the input device. The reflection layer 231 may be attached to the rear surface of the light guide 230.

The touch sensor 220 may be a capacitive touch sensor. The touch information detected by the touch sensor 220 is sent to the light source controller 240.

FIGs. 9A to 9E are diagrams showing various structures of a light guide of the input device of FIG. 1.

For example, the light guide 230 may include the first light guide layer 230a and the second light guide layer 230b.

As shown in FIG. 9A, the first light source 210a included in the first light source unit 210 to output the red light and the second light 215a included in the second light source unit 215 to output the green light may be provided on the first light guide layer 230a. The third light source 210b included in the first light source unit 210 to output the green light and the fourth light 215b included in the second light source unit 215 to output the blue light may be provided on the second light guide layer 230b.

One light source may be provided on each of the two light guide layers.

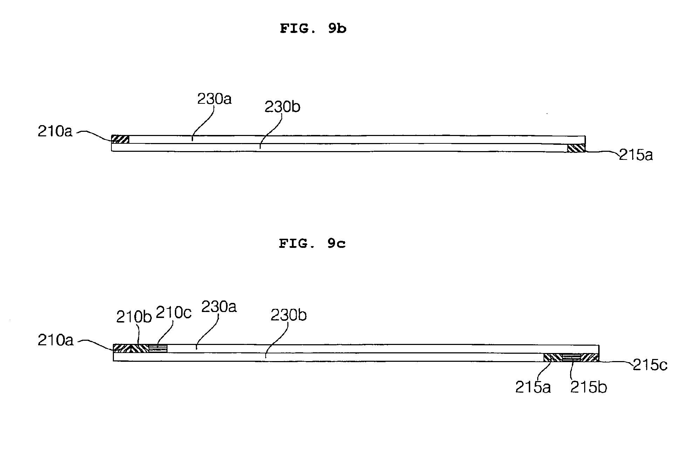

As shown in FIG. 9B, the first light source 210a included in the first light source unit 210 to output the red light may be provided on the first light guide layer 230a and the second light source 215a included in the second light source unit 215 to output the green light may be provided on the second light guide layer 230b.

As another example, only light sources belonging to the first light source unit 210 may be provided on any one of the two light guide layers and only light sources belonging to the second light source unit 215 may be provided on the other light guide layer.

As shown in FIG. 9C, the first, second and third light sources 210a, 210b and 210c included in the first light source unit 210 to output light having different colors may be provided on the first light guide layer 230a and the fourth, fifth and sixth light sources 215a, 215b and 215c included in the second light source unit 215 to output light having different colors may be provided on the second light guide layer 230b.

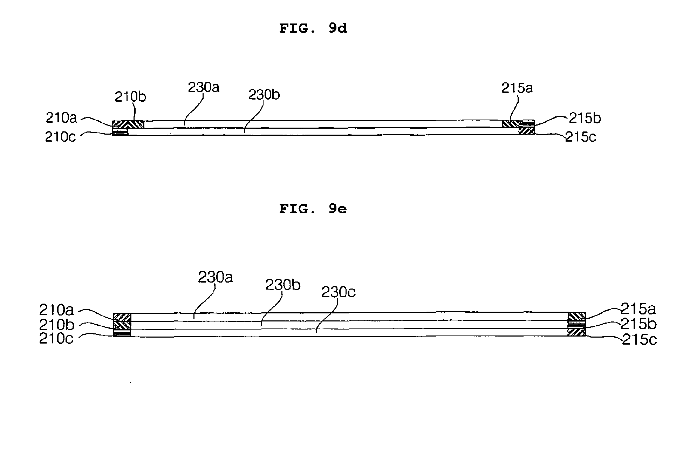

As shown in FIG. 9D, the red light source 210a and the green light source 210b belonging to the first light source unit 210 and the green light source 215a and the blue light source 215b belonging to the second light source unit 215 are provided on any one light guide layer 230a of the two light guide layer, and the blue light source 210c belonging to the first light source unit and the red light source 215c belonging to the second light source unit 215 may be provided on the other light guide layer 230b.

As another example, the light guide 230 may include a first light guide layer 230a, a second light guide layer 230b and a third light guide layer 230c.

As shown in FIG. 9E, the red light source 210 belonging to the first light source unit and the green light source 215a belonging to the second light source unit may be provided on the first light guide layer 230a, the green light source 210b belonging to the first light source unit and the blue light source 215b belonging to the second light source unit may be provided on the second light guide layer 230b, and the blue light source 210c belonging to the first light source unit 210 and the red light source 215c belonging to the second light source unit 215 may be provided on the third light guide layer 230c.

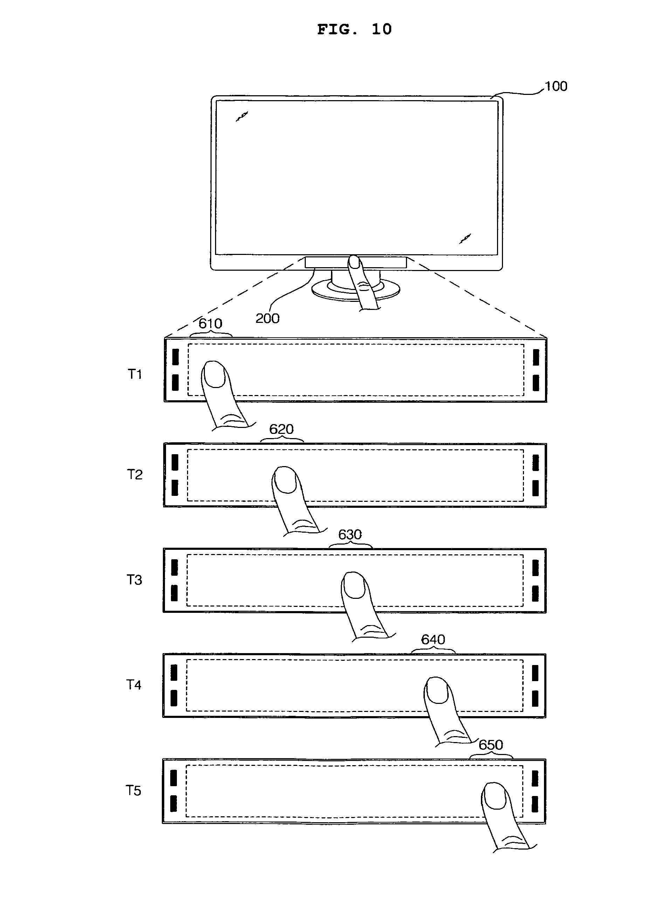

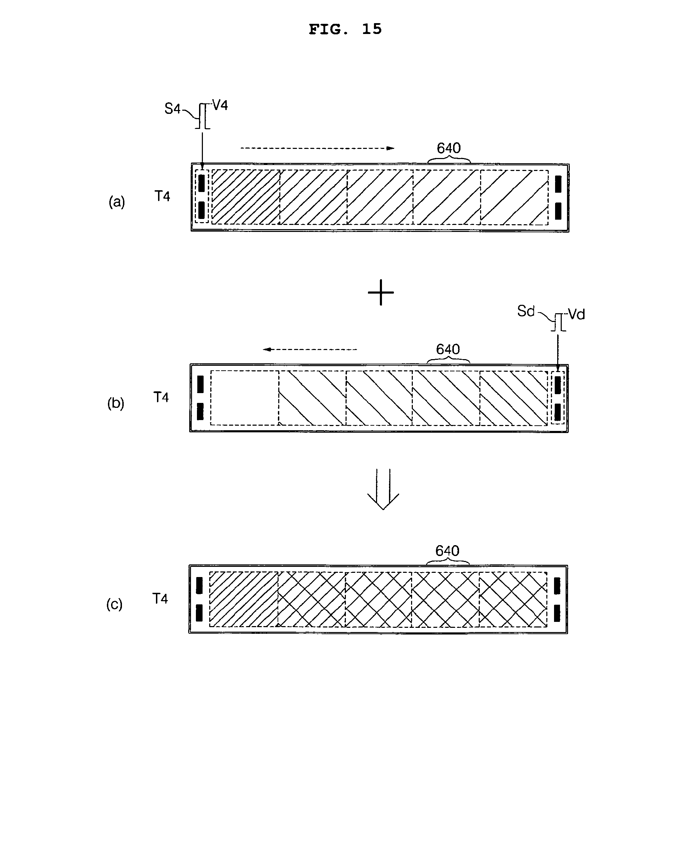

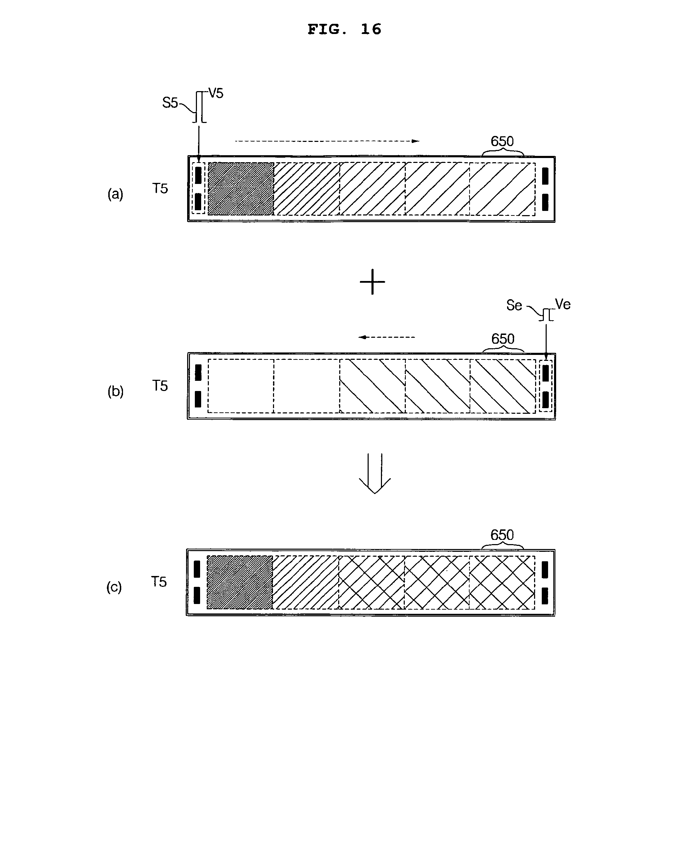

FIGs. 10 to 16 are diagrams showing various examples of light display according to touch input positions of the input device of FIG. 1.

First, referring to FIG. 10, the touch input position of the user's finger is located at a first position 610 close to the first light source unit 210 at a first time T1 and is then moved to a second position 620 from the first light source unit 210 toward the second light source unit 215 at a second time T2. Then, the touch input position is moved to a middle position 630 between the first light source unit 210 and the second light source unit 215 at a third time T3, is moved to a fourth position 640 close to the second light source unit 215 at a fourth time T4, and is moved to a fifth position 650 closer to the second light source unit 215 at a fifth time T5.

As shown in FIG. 10, the light source controller 250 controls the first light source unit 210 or the second light source unit 215 such that at least one of the amount of light emitted from the first light source unit 210 or the amount of light emitted from the second light source unit 215 is changed if the touch input position is changed.

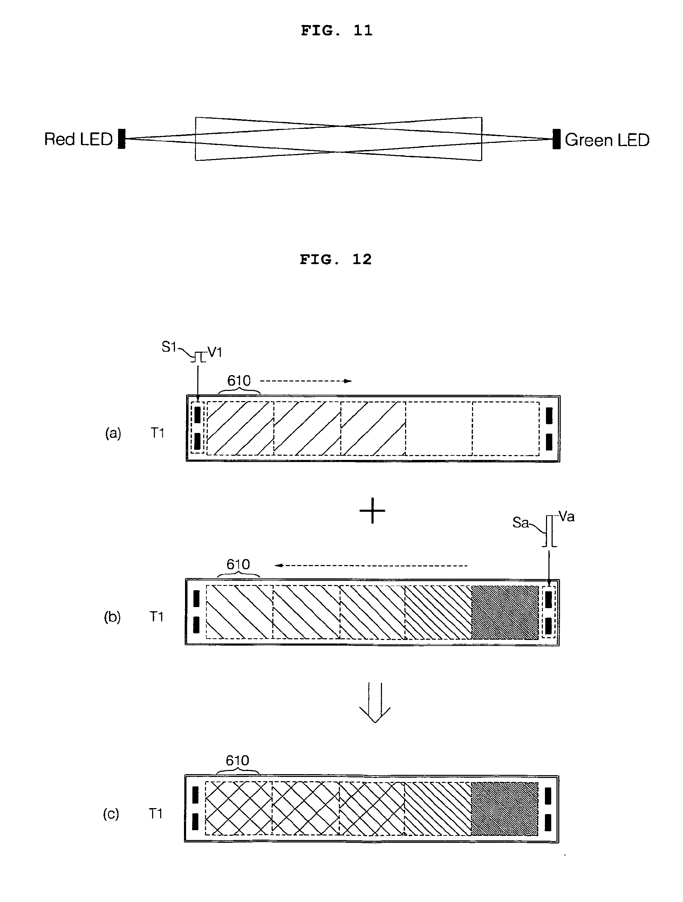

FIG. 11 shows the principle of synthesizing the light emitted from the first light source unit 210 and the light emitted from the second light source unit 215 according to the embodiment of the present invention.

In the embodiment of the present invention, in synthesis of red, green and blue light, the light synthesis principle of red+green=yellow, green+blue=cyan, red+blue=magenta and red+blue+green=white is used.

As described above, the first light source unit 210 emits the red light and the second light source unit 215 emits the green light. The light guide 220 guides the red light to the second light source unit 215 and guides the green light to the first light source unit 210. If the amount of light emitted from the first light source unit 210 and the amount of light emitted from the second light source unit 215 are identical, as shown in FIG. 8, a yellow light which is obtained by synthesizing the red light and the green light is displayed on the middle position 630 of the input device 200.

That is, the intensity of the red light emitted from the first light source unit 210 is gradually decreased toward the second light source unit 215 and the intensity of the green light emitted from the second light source unit 215 is gradually decreased toward the first light source unit 210 such that the yellow light is displayed on the middle position 630 of the input device 200.

Hereinafter, the light guide including a plurality of light guide layers according to the embodiment of the present invention, in which the first light source unit emits the red light and the second light source unit emits the green light, will be described.

FIG. 12 shows light displayed on the input device 200 in correspondence with the first time T1 of FIG. 10.

Referring to FIG. 12, if the touch input position of the user's finger is the first position 610 at the first time T1, the amount of light emitted from the first light source unit 210 is decreased or the amount of light emitted from the second light source unit 215 such that the yellow light is displayed at the first position 610.

If the amount of light of each light source unit 210 or 215 is adjusted by a PAM method, the light source controller 250 may decrease the level of the signal input to the first light source unit 210 or increase the level of the signal input to the second light source unit 215.

If the amount of light of each light source unit 210 or 215 is adjusted by a PWM method, the light source controller 250 may decrease the pulse width of the signal input to the first light source unit 210 or increase the pulse width of the signal input to the second light source unit 215.

FIG. 12(a) shows the case where the first electrical signal S1 having a first level V1 is applied to the first light source unit 210 according to a PAM method such that the light emitted from the first light source unit 210 is directed to the second light source unit 215 via the light guide. The first level V1 may be a minimum level and the light emitted from the first light source unit 210 may be partially guided.

In FIG. 12(a), for convenience of description, the red light emitted from the first light source unit 210 is denoted by an oblique line having an angle of +45 degrees, and a gap between the oblique lines is gradually reduced toward the first light source unit 210.

FIG. 12(b) shows the case where the second electrical signal S2 having a predetermined level Va is applied to the second light source unit 215 according to a PAM method such that the light emitted from the second light source unit 215 is directed to the first light source unit 210 via the light guide. The predetermined level Va may be a maximum level and the amount of light emitted from the second light source unit 215 may be greater than the amount of light emitted from the first light source unit 210.

In FIG. 12(b), for convenience of description, the green light emitted from the first light source unit 210 is denoted by an oblique line having an angle of -45 degrees, and a gap between the oblique lines is gradually reduced toward the second light source unit 215.

FIG. 12(c) shows the case where the red light of FIG. 12(a) and the green light of FIG. 12(b) are synthesized. In particular, the position of the yellow light obtained by synthesizing the red light and the green light is the first position 610.

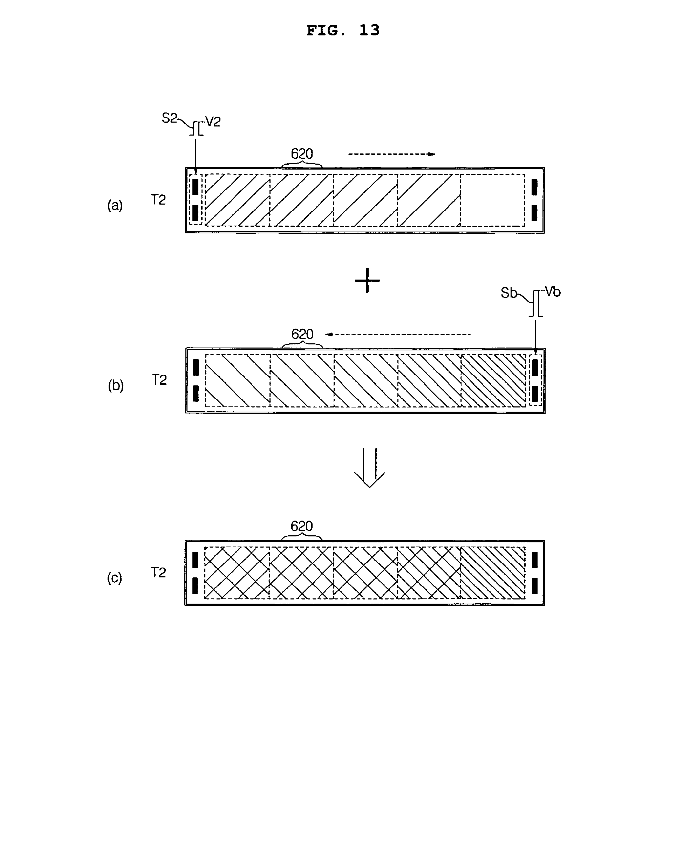

Next, FIG. 13 shows light displayed on the input device 200 in correspondence with the second time T2 of FIG. 10.

In comparison with FIG. 12, first, FIG. 13(a) shows the case where the first electrical signal S1 having a second level V2 is applied to the first light source unit 210 such that the light emitted from the first light source unit 210 is directed to the second light source unit 215 via the light guide. The second level is greater than the first level V1 of FIG. 12(a) and the amount of light emitted from the first light source unit 210 is increased as compared to FIG. 12.

FIG. 13(b) shows the case where the second electrical signal S2 having a predetermined level Vb is applied to the second light source unit 215 such that the light emitted from the second light source unit 215 is directed to the first light source unit 210 via the light guide. The predetermined level Vb is less than the level Va of FIG. 12(b) and the amount of light emitted from the second light source unit 215 is decreased as compared to FIG. 12.

FIG. 13(c) shows the case where the red light of FIG. 13(a) and the green light of FIG. 13(b) are synthesized. In particular, the position of the yellow light obtained by synthesizing the red light and the green light is the first position 620.

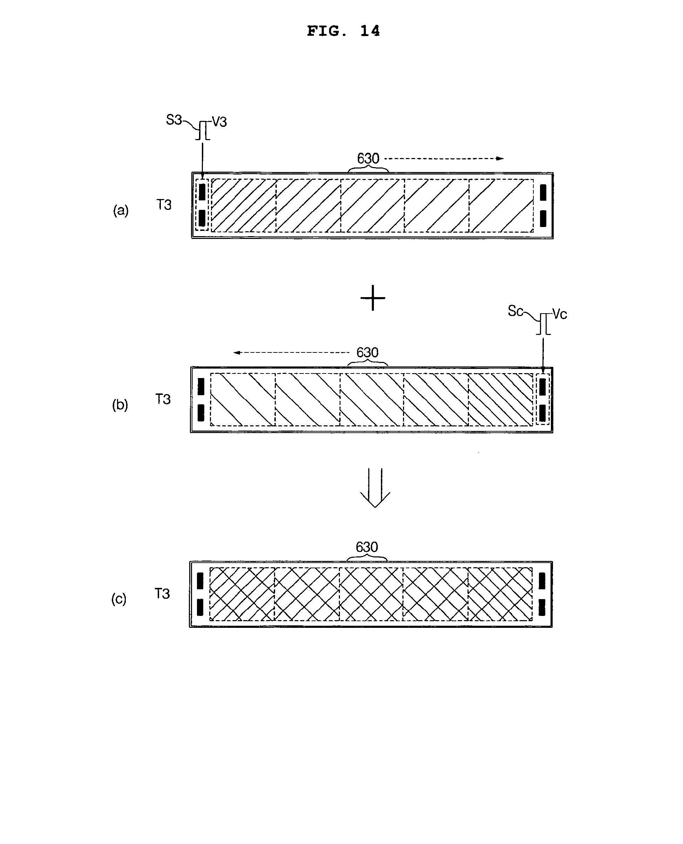

In this way, FIGs. 14 to 16 show the case where the amount of light is gradually increased as the level of the first electrical signal S1 input to the first light source unit 210 is gradually increased in order of V3, V4 and V5 and the amount of light is gradually decreased as the level of the second electrical signal S2 input to the second light source unit 215 is gradually decreased in order of Vc, Vd and Ve.

It can be seen that the position of the yellow light obtained by synthesizing the red light and the green light is changed in order of the third position 630, the fourth position 640 and the fifth position 650.

According to FIGs. 12 to 16, when the touch input position is moved, a moving effect or a gradation effect is generated by adjusting the amount of light. Therefore, the user perceives an interactive effect by touch input.

Although FIGs. 12 to 16 show the case where the touch input position moves from the left to the right, when the touch input position reversely moves from the right to the left, the amount of light may be reversely adjusted from the fifth time T5 to the first time Ti.

If the touch input position is located at the first light source unit 210 or the second light source unit 215, the light source controller 250 may turn any one of the first light source unit 210 or the second light source unit 215 off.

For example, if the touch input position is located at the first light source unit 210, the light source controller 250 may supply an off signal to the first light source unit 210 such that the red light is not emitted from the first light source unit 210. At this time, the second light source unit 215 may emit the green light. Therefore, the light guide 230 may emit only the green light emitted from the second light source unit 215.

As another example, if the touch input position is located at the first light source unit 210, the light source controller 250 may supply an off signal to the second light source unit 215 such that the green light is not emitted from the second light source unit 215. At this time, the first light source unit 210 may emit the red light. Therefore, the light guide 230 may emit only the red light emitted from the first light source unit 210.

As another example, if the touch input position is located at the second light source unit 215, only the red light or the green light may be emitted.

If a plurality of input keys is displayed on the substrate 205, the light source controller 250 determines that an input key corresponding to a touch input position among the plurality of input keys is operated.

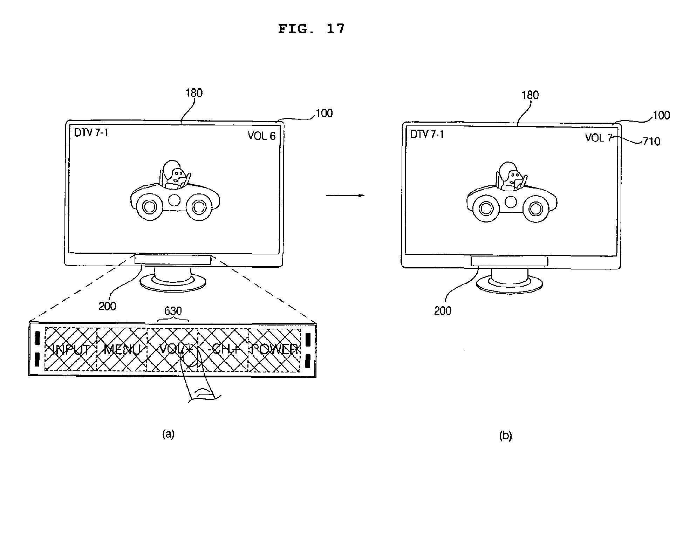

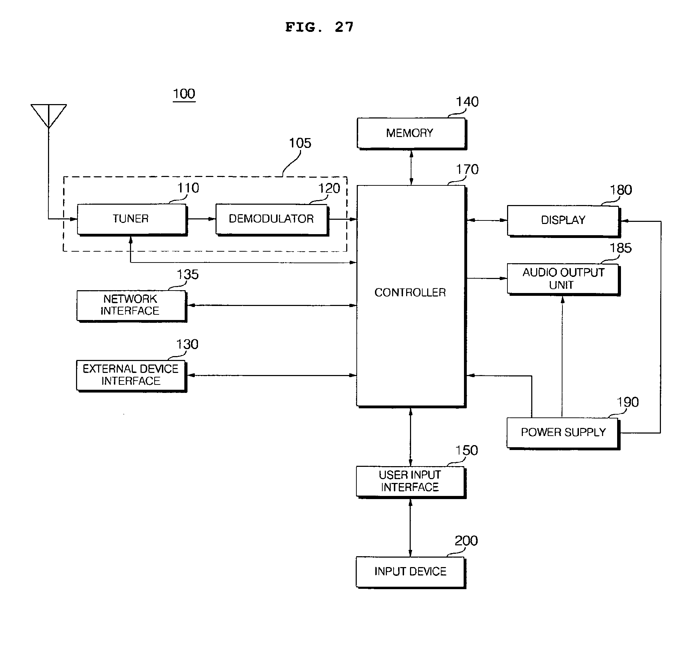

As described above, a plurality of input keys such as an input key, a menu key, a volume key, a channel key and a power key may be displayed on the substrate 205. If the touch input position is located at any one of the plurality of input keys, the light source controller 250 determines that an operation corresponding to the input key is performed. Thus, the light source controller sends a corresponding signal to a controller (170 of FIG. 27) of the image display apparatus 10 including the input device 200, which will be described below with reference to FIGs. 17 to 19.

FIGs. 17 to 19 are diagrams showing various operation examples of the image display apparatus corresponding to touch input positions.

As described above, in a state in which a plurality of input keys such as an input key, a menu key, a volume key, a channel key and a power key is displayed on the substrate 205, as shown in FIG. 17(a), if the touch input position is located at the middle position 630 corresponding to the volume key and, more particularly, a Volume Up (VOL+) key of the volume key, as shown in FIG. 17(b), the audio volume of the image display apparatus 100 is increased. In FIG. 17, an object 701 representing Volume Up is shown.

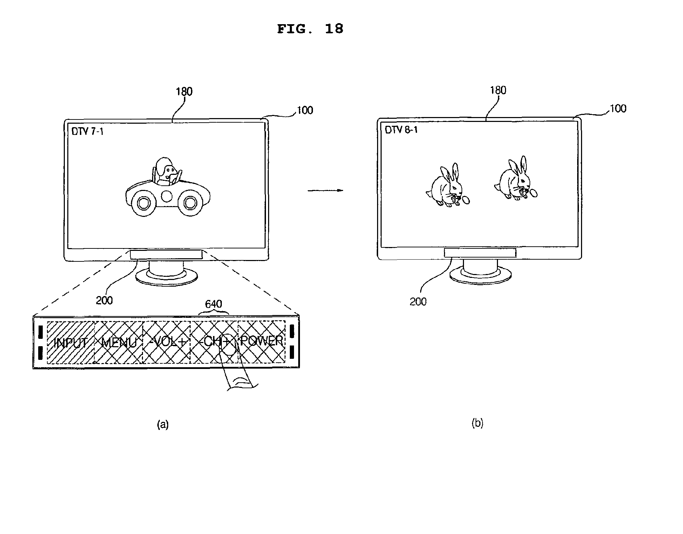

Next, in a state in which the plurality of input keys is displayed on the substrate 205, as shown in FIG. 18(a), if the touch input position is located at the fourth position 640 corresponding to the channel key and, more particularly, a Channel Up (CH+) key of the channel key, as shown in FIG. 18(b), the channel of the image display apparatus 100 may be increased. In FIG. 18, the channel is increased from DTV 7-1 to DTV 8-1.

Next, in a state in which the plurality of input keys is displayed on the substrate 205, as shown in FIG. 19(a), if the touch input position is located at the second position 620 corresponding to the menu key, as shown in FIG. 19(b), a menu object 910 may be displayed on a display 180 of the image display apparatus 100. In FIG. 19, a menu object 910 representing a home menu item, a channel (CH) browser item, a DVR item, etc. is shown.

As another example of the menu object, if the image display apparatus 100 is a monitor, the menu object may include a brightness control item, a definition control item, an image quality control item, a horizontal position control item, a vertical position control item, an OSD language control item, etc.

It is possible to simply perform volume control, channel control, menu display, etc. corresponding to the touch input position while the synthesized light is emitted from the input device 200 according to the touch input position. Therefore, it is possible to increase user convenience. In addition, it is possible to perform a power on/off function of the image display apparatus 100.

Without separately providing a light source to each input key, the light corresponding to each input key is displayed using the light source units 210 and 215 located at both ends of the input device 200, thereby reducing manufacturing costs.

FIG. 20 is a diagram showing another example of a coupling structure of the input device of FIG. 1, and FIG. 21 is a diagram showing various examples of light display according to touch input positions of the input device of FIG. 20.

Referring to FIG. 20, the light guide 230 may include at least one of a first direction pattern from the first light source unit 210 to the second light source unit 215 or a second direction pattern from the second light source unit 215 to the first light source unit 210.

In FIG. 20, a plurality of first direction patterns 1110 from the first light source unit 210 to the second light source unit 215 is formed. The first direction patterns 1110 may be formed on the light guide 230 in a groove shape or an insertion shape.

Unlike FIG. 20, the first direction patterns may be formed on the substrate 205. More specifically, the first direction patterns may be formed on a lower surface of the substrate 205 which is in contact with the light guide 230.

As shown in FIG. 21, when the touch input position is moved from the second position 620 to the fourth position 640 through the third position 630, the amount of light emitted from the first light source unit 210 is changed, the amount of light emitted from the second light source unit 215 is changed, the light obtained by synthesizing the light emitted from the first and second light source units is changed, and the directivity of the light is increased by the first direction patterns 1110. Accordingly, it is possible to increase the interactive effect.

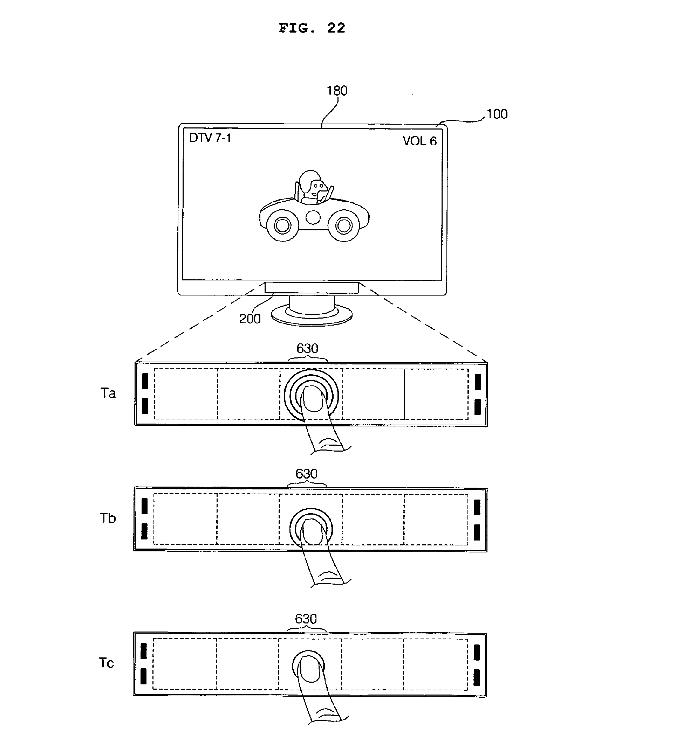

FIGs. 22 to 25 are diagrams showing various examples of light display according to touch input strength of the input device of FIG. 1.

In each of the input devices of FIGs. 22 to 25, each of the first light source unit 210 and the second light source unit 215 includes a plurality of light sources for emitting light having different colors.

That is, the first light source unit 210 may include a red light source, a green light source and a blue light source. The second light source unit 215 may include a green light source, a blue light source and a red light source. Hereinafter, the structure of the light guide of FIG. 9E will be described.

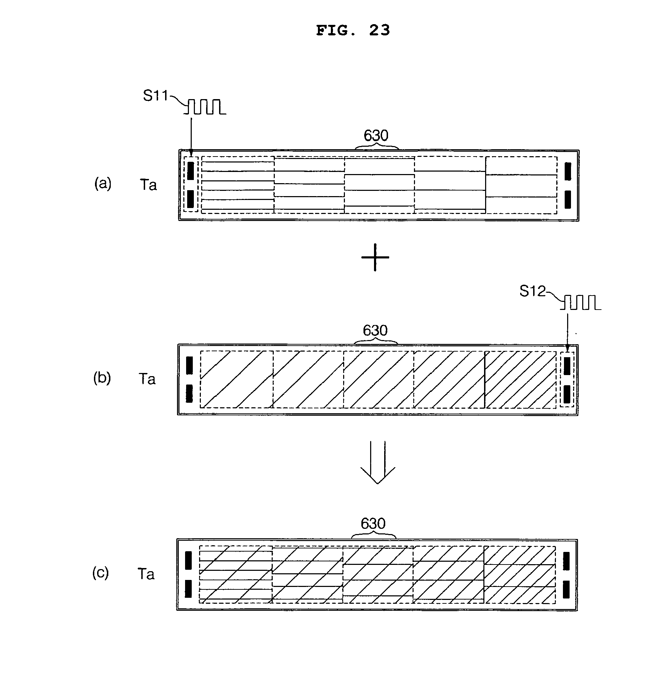

First, at a time Ta of FIG. 22, if the strength of the touch input is highest (corresponding to three-time touch or a third touch duration) in a state in which the touch input position is located at the middle position 630, the light sources 210c and 215c provided on the third light guide layer 230c among the plurality of light guide layers may emit light. That is, as shown in FIG. 23, the first light source unit 210 may emit the blue light and the second light source unit 215 may emit the red light.

FIG. 23(a) shows the case of applying a first electrical signal S11 having three pulses to the first light source unit 210 according to the strength of the touch input. Then, the light sources 210c and 215c provided on the third light guide layer 230c among the plurality of light guide layers may emit light. That is, the blue light is emitted from the first light source unit 210 and is directed to the second light source unit 215 through the light guide. In FIG. 23, the blue light is denoted by a horizontal line.

FIG. 23(b) shows the case of applying a second electrical signal S12 having three pulses to the second light source unit 215 according to the strength of the touch input. Then, the light sources 210c and 215c provided on the third light guide layer 230c among the plurality of light guide layers may emit light. That is, the red light is emitted from the second light source unit 215 and is directed to the first light source unit 210 through the light guide. In FIG. 23, the red light is denoted by an oblique line having an angle of +45 degrees.

FIG. 23(c) shows the case of synthesizing the blue light of FIG. 23(a) and the red light of Fig. 23(b) by the third light guide layer 230c. In particular, magenta light may be displayed at the middle position 630.

If the touch input position is changed, similarly to FIG. 10, at least one of the amount of blue light emitted from the first light source unit 210 or the amount of red light emitted from the second light source unit 215 is changed.

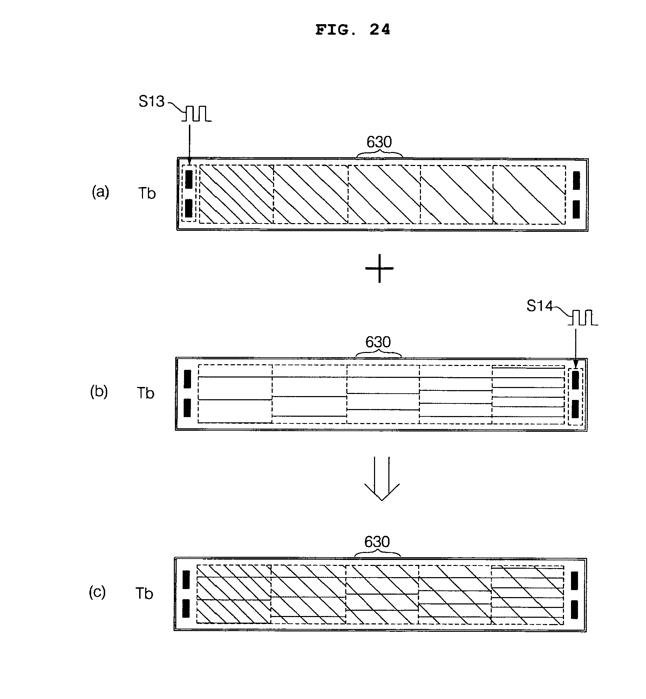

Next, at a time Tb of FIG. 22, if the strength of the touch input is middle (corresponding to two-time touch or a second touch duration) in a state in which the touch input position is located at the middle position 630, the light sources 210b and 215b provided on the second light guide layer 230b among the plurality of light guide layers may emit light. That is, as shown in FIG. 24, the first light source unit 210 may emit the green light and the second light source unit 215 may emit the blue light.

FIG. 24(a) shows the case of applying a first electrical signal S13 having two pulses to the first light source unit 210 according to the strength of the touch input. Then, the light sources 210b and 215b provided on the second light guide layer 230b among the plurality of light guide layers may emit light. That is, the green light is emitted from the first light source unit 210 and is directed to the second light source unit 215 through the light guide. In FIG. 24, the green light is denoted by an oblique line having an angle of -45 degrees.

FIG. 24(b) shows the case of applying a second electrical signal S14 having two pulses to the second light source unit 215 according to the strength of the touch input. Then, the light sources 210b and 215b provided on the second light guide layer 230b among the plurality of light guide layers may emit light. That is, the blue light is emitted from the second light source unit 215 and is directed to the first light source unit 210 through the light guide. In FIG. 24, the blue light is denoted by a horizontal line.

FIG. 24(c) shows the case of synthesizing the green light of FIG. 24(a) and the blue light of Fig. 24(b) by the second light guide layer 230b. In particular, cyan light may be displayed at the middle position 630.

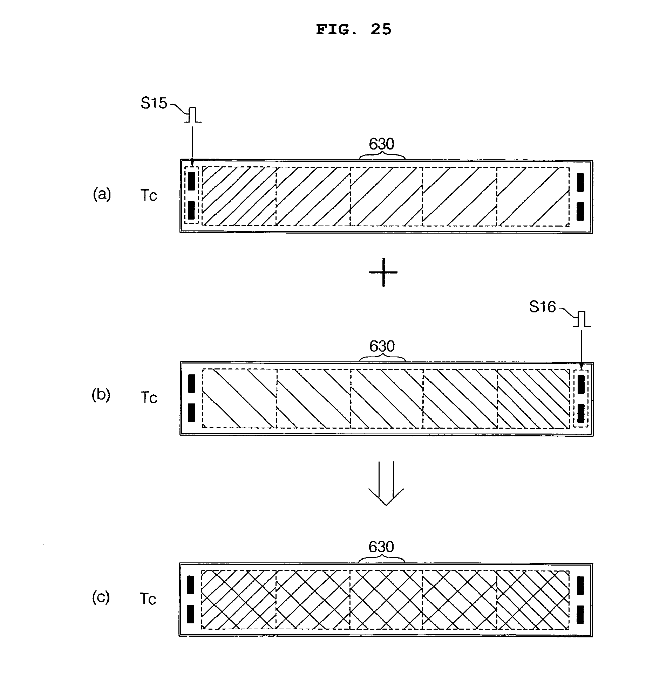

Next, at a time Tc of FIG. 22, if the strength of the touch input is lowest (corresponding to one-time touch or a first touch duration) in a state in which the touch input position is located at the middle position 630, the light sources 210a and 215a provided on the first light guide layer 230a among the plurality of light guide layers may emit light. That is, as shown in FIG. 25, the first light source unit 210 may emit the red light and the second light source unit 215 may emit the green light.

FIG. 25(a) shows the case of applying a first electrical signal S15 having one pulse to the first light source unit 210 according to the strength of the touch input. Then, the light sources 210a and 215a provided on the first light guide layer 230a among the plurality of light guide layers may emit light. That is, the red light is emitted from the first light source unit 210 and is directed to the second light source unit 215 through the light guide. In FIG. 25, the red light is denoted by an oblique line having an angle of +45 degrees.

FIG. 25(b) shows the case of applying a second electrical signal S16 having one pulse to the second light source unit 215 according to the strength of the touch input. Then, the light sources 210a and 215a provided on the first light guide layer 230a among the plurality of light guide layers may emit light. That is, the green light is emitted from the second light source unit 215 and is directed to the first light source unit 210 through the light guide. In FIG. 25, the green light is denoted by an oblique line having an angle of -45 degrees.

FIG. 25(c) shows the case of synthesizing the red light of FIG. 25(a) and the green light of Fig. 25(b) by the first light guide layer 230a. In particular, yellow light may be displayed at the middle position 630.

Therefore, by changing at least one of the color of the light emitted from the first light source unit or the color of the light emitted from the second light source unit, it is possible to variously implement the interactive effect during touch input.

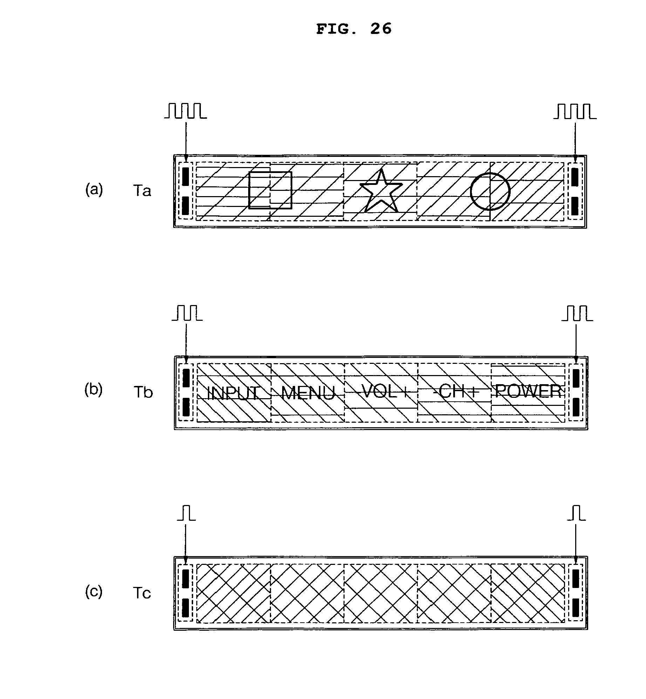

FIG. 26 is a diagram showing various examples of light display according to touch input strength.

For example, in the structure of the input device, as shown in FIG. 7 or 8, if a pattern is not formed in the first light guide layer 230a, text patterns are formed in the second light guide layer 230b, and figure patterns are formed in the third light guide layer 230c, the light guide layer may selectively output the synthesized light according to touch strength.

First, at a time Ta of FIG. 22, if the strength of the touch input is highest (corresponding to three-time touch or a third touch duration) in a state in which the touch input position is located at the middle position 630, the light sources 210c and 215c provided on the third light guide layer 230c among the plurality of light guide layers may emit light. That is, as shown in FIG. 26(a), the light synthesized by the third light guide layer 230c and the figure patterns formed in the third light guide layer 230c are displayed. Thus, the user may perform an input operation according to the figure patterns.

In the third light guide layer 230c in which the figure patterns are formed, the light source 210c of the first light source unit and the light source 215c of the second light source unit may output light having the same color.

Next, at a time Tb of FIG. 22, if the strength of the touch input is middle (corresponding to two-time touch or a second touch duration) in a state in which the touch input position is located at the middle position 630, the light sources 210b and 215b provided on the second light guide layer 230b among the plurality of light guide layers may emit light. That is, as shown in FIG. 26(b), the light synthesized by the second light guide layer 230b and the text patterns formed in the second light guide layer 230b are displayed. Thus, the user may perform an input operation according to the text patterns.

In the second light guide layer 230b in which the text patterns are formed, the light source 210b of the first light source unit and the light source 215b of the second light source unit may output light having the same color.

Next, at a time Tc of FIG. 22, if the strength of the touch input is lowest (corresponding to one-time touch or a first touch duration) in a state in which the touch input position is located at the middle position 630, the light sources 210a and 215a provided on the first light guide layer 230a among the plurality of light guide layers may emit light. That is, as shown in FIG. 26(c), the light synthesized by the first light guide layer 230a is displayed. For example, the first light source unit 210 may emit the red light and the second light source unit 215 may emit the green light.

Unlike the figure, the number of light guide layers for emitting light may be increased as the number of times of touch, the touch strength or the touch duration of the touch input is increased.

For example, if the strength of the touch input is highest (corresponding to three-time touch or a third touch duration), the light sources 210a, 210b and 210c of the first light source unit may emit light and the light sources 215a, 215b and 215c of the second light source unit may emit light such that all light guide layers 230a, 230b and 230c emit light.

As another example, if the strength of the touch input is middle (corresponding to two-time touch or a second touch duration), the light sources 210a and 210b of the first light source unit may emit light and the light sources 215a and 215b of the second light source unit may emit light such that light guide layers 230a and 230b emit light.

As another example, if the strength of the touch input is lowest (corresponding to one-time touch or a first touch duration), the light source 210a of the first light source unit may emit light and the light source 215a of the second light source unit may emit light such that light guide layers 230a emits light.

FIG. 27 is a block diagram of the image display apparatus of FIG. 1.

Referring to FIG. 27, the image display apparatus according to the embodiment of the present invention may be a broadcast display apparatus.

The image display apparatus 100 may include a broadcast receiver 105, an external device interface 130, a network interface 135, a memory 140, a user input interface 150, a controller 170, a display 180, an audio output unit 185, a power supply 190 and an input device 200.

The broadcast receiver 105 may include a tuner 110, a demodulator 120 and a network interface 135. As needed, only the tuner 110 and the demodulator may be included or only the network interface 135 may be included.

The tuner 110 tunes to a Radio Frequency (RF) broadcast signal corresponding to a channel selected by a user from among RF broadcast signals received through an antenna or RF broadcast signals corresponding to all channels previously stored in the image display apparatus. The tuned RF broadcast is converted into an Intermediate Frequency (IF) signal or a baseband Audio/Video (AV) signal.

The demodulator 120 receives the digital IF signal DIF from the tuner 110 and demodulates the digital IF signal DIF. The demodulator 120 may perform demodulation and channel decoding, thereby obtaining a stream signal. The stream signal may be a signal in which a video signal, an audio signal and a data signal are multiplexed.

The stream signal output from the demodulator 120 may be input to the controller 170 and thus subjected to demultiplexing and A/V signal processing. The processed video and audio signals are output to the display 180 and the audio output unit 185, respectively.

The external device interface 130 may serve as an interface between an external device and the image display apparatus 100. For interfacing, the external device interface 130 may include an A/V Input/Output (I/O) unit (not shown) and/or a wireless communication module (not shown).

The network interface 135 serves as an interface between the image display apparatus 100 and a wired/wireless network such as the Internet. The network interface 135 may receive content or data provided by an Internet or content provider or a network operator over a network.

The memory 140 may store various programs necessary for the controller 170 to process and control signals, and may also store processed video, audio and data signals.

The memory 140 may temporarily store a video, audio and/or data signal received from the external device interface 130. The memory 140 may store information about a predetermined broadcast channel by the channel storage function.

The user input interface 150 transmits a signal input by the user to the controller 170 or transmits a signal received from the controller 170 to the user.

The input device 200 may synthesize the light emitted from the first light source unit and the light emitted from the second light source unit so as to output the synthesized light and change and output at least one of the amount of light emitted from the first light source unit or the second light source unit according to the touch input position.

The input device 200 may output the light such that the amount of light emitted from the first light source unit and the amount of light emitted from the second light source unit are inversely proportional to each other according to the touch input position.

The input device 200 may change at least one of the amount of light emitted from the first light source unit or the amount of light emitted from the second light source unit according to the number of times of touch input or the strength of the touch input.

The input device 200 may change at least one of the color of the light emitted from the first light source unit or the color of the light emitted from the second light source unit according to the number of times of touch input or the strength of the touch input.

The touch input position information, the touch input number information or the touch input strength information of the input device 200 may be input to the controller 170 through the user input interface 150.

The input device 200 according to the embodiment of the present invention may be any one of the input devices described with reference to FIGs. 1 to 25, which will be omitted herein.

The controller 170 may perform an operation corresponding to the touch input from the input device 200.

For example, in a state in which a plurality of input keys such as an input key, a menu key, a volume key, a channel key and a power key is displayed on the substrate 205, the volume may be controlled as shown in FIG. 17, the channel may be controlled as shown in FIG. 18, or the menu object may be displayed as shown in FIG. 19. In addition, the power on/off operation of the image display apparatus 100 may be performed.

The controller 170 may control the display of an object corresponding to a touch input position. The object 710 representing Volume Up may be displayed on the display 180 as shown in FIG. 17 or the menu object 910 may be displayed as shown in FIG. 19. Therefore, the user can confirm the operation associated with the input device 200 through the display 180.

If the image display apparatus 100 is a monitor, the controller 170 may control the display of the menu object including a brightness control item, a definition control item, an image quality control item, a horizontal position control item, a vertical position control item, an OSD language control item, etc.

The controller 170 may demultiplex the stream signal received from the tuner 110, the demodulator 120, or the external device interface 130 into a number of signals, process the demultiplexed signals into audio and video data, and output the audio and video data.

The video signal processed by the controller 170 may be displayed as an image on the display 180. The video signal processed by the controller 170 may also be transmitted to an external output device through the external device interface 130.

The audio signal processed by the controller 170 may be output to the audio output unit 185. Also, the audio signal processed by the controller 170 may be transmitted to the external output device through the external device interface 130.

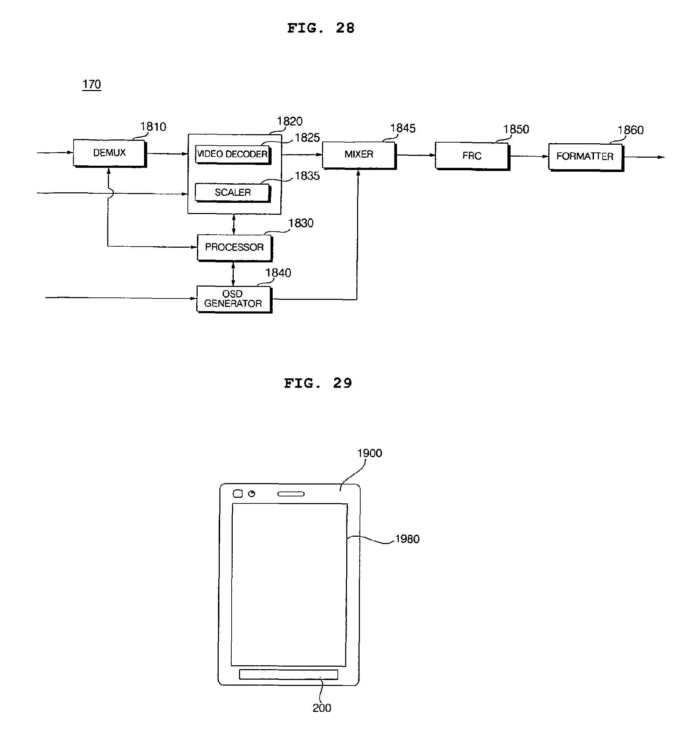

While not shown in FIG. 27, the controller 170 may include a DEMUX, a video processor, etc., which will be described below with reference to FIG. 28.

The display 180 converts the video signal, the data signal, the OSD signal and the control signal processed by the controller 170 or the video signal, the data signal and the control signal received by the external device interface 130 and generates a driving signal.

The display 180 may be a projector, a Plasma Display Panel (PDP), a Liquid Crystal Display (LCD), an Organic Light-Emitting Diode (OLED) display or a flexible display. In particular, in the embodiment of the present invention, the display 180 may be a 3D display.

The audio output unit 185 receives the audio signal processed by the controller 170 and outputs the received audio signal as sound.

The power supply 190 supplies power to the image display apparatus 100. Particularly, the power supply 190 may supply power to the controller 170 which may be implemented as a System On Chip (SOC), the display 180 for displaying the video signal, and the audio output unit 185 for outputting the audio signal.

The power supply 190 may include a converter (not shown) for converting an AC voltage into a DC voltage. The power supply 190 may further include a DC/DC converter for changing the level of the DC voltage and outputting the DC voltage with the changed level.

The block diagram of the image display apparatus 100 shown in FIG. 27 is an embodiment of the present invention. Some of the components of the block diagram of FIG. 27 may be combined or omitted and new components may be added to the block diagram of FIG. 23.

The image display apparatus 100 according to one embodiment of the present invention may be an image display apparatus without a broadcast reception function, e.g., a monitor. In this case, the above-described broadcast receiver 105 may not be included.

FIG. 28 is a block diagram of the controller of FIG. 27.

Referring to FIG. 28, the controller 170 according to one embodiment of the present invention includes a DEMUX 1810, a video processor 1820, a processor 1830, an OSD generator 1840, a mixer 1845, a frame rate converter (FRC) 1850, and a formatter 1860. The controller 170 may further include an audio processor (not shown) and a data processor (not shown).

The DEMUX 1810 demultiplexes an input stream into a video signal, an audio signal, and a data signal. The stream signal input to the DEMUX 1810 may be received from the tuner 110, the demodulator 120 or the external device interface 135.

The video processor 1820 may process the demultiplexed video signal. For video signal processing, the video processor 1820 may include a video decoder 1825 and a scaler 1835.

The video decoder 1825 decodes the demultiplexed video signal and the scaler 1835 scales the resolution of the decoded video signal so that the video signal can be displayed on the display 180.

The video decoder 1825 may be provided with decoders that operate based on various standards.

The processor 1830 may control the overall operation of the image display apparatus 100 or the controller 170. For example, the processor 1830 controls the tuner 110 to tune to a channel selected by the user and controls the image display apparatus 100 by a user command input through the user input interface 150 or an internal program.

The processor 1830 may control the operations of the DEMUX 1810, the video processor 1820 and the OSD generator 1840 of the controller 170.

The OSD generator 1840 generates an OSD signal autonomously or according to user input. For example, the OSD generator 1840 may generate signals, by which a variety of information is displayed as images or text on the screen of the display 180, according to a user input signal received through the input device 200. The OSD signal may include various data such as a UI, a variety of menu screens, widgets, icons, etc. of the image display apparatus 100.

The mixer 1845 may mix the decoded video signal processed by the video processor 1820 with the OSD signal generated by the OSD generator 1840 and output the mixed signal to the FRC 1850.

The FRC 1850 may change the frame rate of an input image. The FRC 1850 may maintain the frame rate of the input image without frame rate conversion.

The formatter 1860 receives the mixed signal from the mixer 1845, that is, the OSD signal and the decoded video signal, changes the format of the mixed signal to be suitable for the display 180. For example, the formatter 1860 may convert a received signal into an RGB data signal. The RGB signal may be output in the form of a Low Voltage Differential Signal (LVDS) or mini-LVDS.

The formatter 1860 may divide the video signal into a 2D image signal and a 3D video signal, for 3D video display. The formatter 1860 may change the format of the 3D video signal or convert a 2D video signal into a 3D video signal.

The audio processor (not shown) of the controller 170 may process the demultiplexed audio signal. For audio signal processing, the audio processor (not shown) may have a plurality of decoders.

The audio processor (not shown) of the controller 170 may also adjust the bass, treble or volume of the audio signal.

The data processor (not shown) of the controller 170 may process the demultiplexed data signal. For example, if the demultiplexed data signal is an encoded signal, the controller 170 may decode the data signal. The encoded data signal may be an EPG which includes broadcasting information specifying the start time, end time, etc. of scheduled broadcast programs.

The block diagram of the controller 170 illustrated in FIG. 28 is an embodiment of the present invention. Depending upon the specifications of the controller 170, the components of the controller 170 may be combined, or omitted. Or new components are added to the controller 170.

In particular, the FRC 1850 and the formatter 1860 may not be included in the controller 170 and may be separately provided or omitted.

FIG. 29 is a diagram showing an image display apparatus including an input device according to another embodiment of the present invention.

Referring to FIG. 29, the image display apparatus 1900 of FIG. 29 may be a mobile terminal including a display 1980 and an input device 200. For example, the mobile terminal 1900 may be a mobile phone, a PMP, an e-book, an MP3 player, a music player, etc.

As described above, the input devices 200 described with reference to FIGS. 1 to 25 are applicable to a mobile terminal. Thus, even in the mobile terminal, it is possible to increase an interactive effect by adjusting the amount of light according to a touch input position.

According to the embodiments of the present invention, if a touch input is performed between first and second light source units arranged spaced apart from each other, at least one of a first electrical signal sent to the first light source unit or a second electrical signal sent to the second light source unit is changed according to touch information such that at least one of the amount of light emitted from the first light source unit or the amount of light emitted from the second light source unit is changed. That is, it is possible to provide an interactive effect during the touch input. Accordingly, it is possible to improve user convenience.

That is, by changing the amount of light emitted from the first light source unit and the amount of light emitted from the second light source unit in inverse proportion to each other according to the touch position information of the touch information, it is possible to increase an interactive effect.

In particular, since at least one of a plurality of light guide layers synthesizes light, it is possible to implement various feedback effects.

By changing at least one of the amount of light emitted from the first light source unit or the amount of light emitted from the second light source unit according to touch number information, touch strength information or touch duration information of the touch information, it is possible to implement various feedback effects.

By changing at least one of the color of light emitted from the first light source unit or the color of light emitted from the second light source unit according to the touch number information, touch strength information or touch duration information of the touch information, it is possible to implement various interactive effects during the touch input.

By operating an input key corresponding to a touch input position among a plurality of input keys displayed on a substrate it is possible to simply implement the input key.

An image display apparatus including an input device according to an embodiment of the present invention displays an object corresponding to a touch input position so as to variously implement a menu configuration according to the position.

As a result, in the image display apparatus including the input device according to the embodiment of the present invention, it is possible to provide various user interfaces and increase user convenience.

The input device and the image display apparatus according to the present invention may be implemented as code that can be written to a computer-readable recording medium and can thus be read by a processor included in an image display device. The computer-readable recording medium may be any type of recording device in which data can be stored in a computer-readable manner. Examples of the computer-readable recording medium include a ROM, a RAM, a CD-ROM, a magnetic tape, a floppy disc, an optical data storage, and a carrier wave (e.g., data transmission over the Internet). The computer-readable recording medium can be distributed over a plurality of computer systems connected to a network so that computer-readable code is written thereto and executed therefrom in a decentralized manner. Functional programs, code, and code segments needed for realizing the embodiments herein can be construed by one of ordinary skill in the art.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. An image display apparatus (100) comprising:
a display (180) to display an image; and
an input device (200) adjacent to the display (180), the input device (200) comprising:
a first light source unit (210) that includes a first light emitting device (LED) to emit a first light of a first color,
a second light source unit (215) that includes a second light emitting device (LED) to emit a second light of a second color,
a light guide (230) having a plurality of light guide layers, wherein a first one of the light guide layers is provided in front of a second one of the light guide layers, wherein the first LED corresponds to the first one of the light guide layers and the second LED corresponds to the second one of the light guide layers, and the light guide (230) combines light from the first light source unit (210) and the second light source unit (215) to provide an output light,
a touch sensor (220) to detect a touch input, and
a light source controller (250) to control an intensity of the output light from the light guide (230) based on the detected touch input.

2. The apparatus according to claim 1, wherein the first light source unit (210) further includes a third LED to emit a third light of a third color, and wherein the third LED corresponds to the first one of the light guide layers.

3. The apparatus according to claim 1, wherein the light source controller (250) controls an intensity of the output light from the light guide (230) by controlling an intensity of the first light from the first one of the light guide layers based on a first detected touch input.

4. The apparatus according to claim 3, wherein the light source controller (250) controls an intensity of the output light from the light guide (230) by controlling an intensity of the second light from the second one of the light guide layers based on a second detected touch input.

5. The apparatus according to claim 1, wherein a first pattern is formed on the first one of the light guide layers, and a second pattern is formed on the second one of the light guide layers.

6. The apparatus according to claim 5, wherein the pattern is a text pattern.

7. The apparatus according to claim 5, wherein the pattern is a figure pattern.

8. The apparatus of claim 1, wherein the light source controller (250) controls the intensity of the output light from the light guide (230) based on one of a position of the touch input, a number of touches, a duration of the touch input, or a touch strength of the touch input.

9. The apparatus of claim 1, wherein the input device is provided in a bezel area of the apparatus adjacent to the display (180).

10. The apparatus according to claim 1, wherein the light source controller (250) increases an amount of the first light emitted from the first LED when the detected touch input is closer to the second light source unit (215) than the first light source unit (210).

11. The apparatus according to claim 1, wherein the light source controller (250) decreases an amount of the second light emitted from the second LED when the detected touch input is closer to the second light source unit (215) than the first light source unit (210).

12. The apparatus according to claim 1, wherein the input device further comprises a substrate (205).

13. The apparatus according to claim 12, wherein a plurality of input keys are displayed on the substrate (205).

14. An input device (200) comprising:
a first light source unit (210) including a first light emitting device (LED) to provide a first light having a first color;
a second light source unit (215) including a second light emitting device (LED) to provide a second light having a second color;
a light guide (230) having a plurality of light guide layers that includes a first light guide layer (230a) in front of a second light guide layer, wherein at least the first LED corresponds to the first light guide layer (230a) and at least the second LED corresponds to the second light guide layer (230b), the light guide (230) to receive the first light from the first LED at a first end of the light guide (230) and the light guide (230) to receive a second light from the second LED at a second end of the light guide (230), and the light guide (230) to output a third light having a third color based on a combination of the first light and the second light;
a touch sensor (220) to determine a touch input; and
a controller (250) to control an intensity of the third light from the light guide (230) based on the determined touch input.

15. The input device (200) according to claim 14, wherein the first light source unit (210) further includes another LED to emit a fourth light of a fourth color, and wherein the another LED corresponds to the first light guide layer (230a).
